(19) Europäisches Patentamt
European Patent Office
Office européen des brevets

(11) **EP 3 196 664 B1**

(12) **EUROPÄISCHE PATENTSCHRIFT**

(45) Veröffentlichungstag und Bekanntmachung des Hinweises auf die Patenterteilung:
**12.10.2022   Patentblatt 2022/41**

(21) Anmeldenummer: **17152310.3**

(22) Anmeldetag: **19.01.2017**

(51) Internationale Patentklassifikation (IPC):
**G01R 31/36** $^{(2020.01)}$     **H01M 10/42** $^{(2006.01)}$

(52) Gemeinsame Patentklassifikation (CPC):
**G01R 31/392;** G01R 31/396; H01M 10/482;
Y02E 60/10

(54) **VERFAHREN UND VORRICHTUNG ZUR ERMITTLUNG EINER VERMINDERTEN KAPAZITÄT EINES ZELLENMODULS EINER BATTERIE**

METHOD AND DEVICE FOR DETERMINING A REDUCED CAPACITY OF A CELL MODULE OF A BATTERY

PROCÉDÉ ET DISPOSITIF DE DÉTERMINATION D'UNE CAPACITÉ RÉDUITE D'UN MODULE DE CELLULES D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.01.2016   DE 102016101031**

(43) Veröffentlichungstag der Anmeldung:
**26.07.2017   Patentblatt 2017/30**

(73) Patentinhaber: **TESVOLT GmbH**
**06886 Lutherstadt Wittenberg (DE)**

(72) Erfinder:
• **Schandert, Simon**
  **06895 Zahna-Elster (DE)**
• **Sterff, Robert**
  **83083 Riederring (DE)**

(74) Vertreter: **Schulz Junghans**
**Patentanwälte PartGmbB**
**Großbeerenstraße 71**
**10963 Berlin (DE)**

(56) Entgegenhaltungen:
WO-A1-2015/041091     DE-A1-102009 002 466
JP-A- H0 968 561     JP-A- 2004 239 748
JP-A- 2005 253 287     KR-B1- 101 160 541
US-A1- 2014 088 896

• **Peter Horn: "Electric Battery", , 20 July 2016 (2016-07-20), XP055684954, Retrieved from the Internet: URL:https://en.wikipedia.org/w/index.php?title=Electric_battery&oldid=730748477**

Bemerkungen:
Die Akte enthält technische Angaben, die nach dem Eingang der Anmeldung eingereicht wurden und die nicht in dieser Patentschrift enthalten sind.

**Beschreibung**

Die vorliegende Erfindung betrifft ein Verfahren sowie eine Vorrichtung zur Ermittlung einer geminderten Kapazität eines Zellenmoduls innerhalb einer mehrere Zellenmodule umfassenden elektrochemischen Batterie, sowie ein Batteriesystem, welches eine erfindungsgemäße Vorrichtung zur Ermittlung einer geminderten Kapazität aufweist, und ein Computerprogramm zur Durchführung des erfindungsgemäßen Verfahrens zur Ermittlung geminderter Kapazität eines Zellenmoduls.

Batterien, die in Reihe oder parallel geschaltete Zellen aufweisen, sind hinlänglich bekannt. In Reihe geschaltete Zellen bilden dabei sogenannte Zellenmodule aus. Je nach Schaltungsart kann durch den Zustand einer einzelnen Zelle oder auch eines einzelnen Zellenmoduls die Spannung oder auch die von der Batterie zur Verfügung gestellte Stromstärke beeinflusst werden.

Insbesondere kann diese Beeinflussung von dem sogenannten SoH (State of Health) einer einzelnen Zelle bzw. eines Zellenmoduls abhängen, der üblicherweise den Alterungszustand dieser Zelle bzw. dieses Zellemoduls kennzeichnet.

Um den Alterungszustand bzw. den SoH von elektrochemischen Batterien mit mehreren seriell geschalteten einzelnen Zellen festzustellen, wird üblicherweise die Ladungsmenge der Batterie über zwei definierte Punkte der Ladekennlinie der gesamten Batteriespannung ermittelt. Nachteilig daran ist jedoch, dass einzelne Zellen oder Zellenmodule, die einen Defekt aufweisen, der z. B. in einer fortgeschrittenen Alterung oder auch mangelhafter Kontaktierung bestehen kann, über diese Messung nicht identifiziert werden können. Das bedeutet, dass bei Feststellung eines gewissen Alterungszustandes bzw. eines erhöhten SoH die gesamte Batterie auszutauschen ist. Ein relevantes Dokument aus dem Stand der Technik ist JP H09 68561 A.

Der vorliegenden Erfindung liegt die Aufgabe zugrunde, ein Verfahren sowie eine Vorrichtung und ein System zur Verfügung zu stellen, mit denen in einfacher, zeitsparender und zuverlässiger Weise der Alterungszustand einzelner Zellen bzw. Zellenmodule einer mehrere Zellenmodule umfassenden elektrochemischen Batterie feststellbar ist, um durch Austausch oder Wartung bzw. Reparatur dieser Zellenmodule den Alterungszustand der gesamten Batterie zu mindern.

Diese Aufgabe wird durch das erfindungsgemäße Verfahren zur Ermittlung einer geminderten Kapazität eines Zellenmoduls nach Anspruch 1 sowie durch die erfindungsgemäße Vorrichtung zur Ermittlung einer geminderten Kapazität eines Zellenmoduls nach Anspruch 7 und durch das erfindungsgemäße Batteriesystem, welches wenigstens eine erfindungsgemäße Vorrichtung zur Ermittlung einer geminderten Kapazität eines Zellenmoduls aufweist, nach Anspruch 8 gelöst.

Die Ermittlung der Soll-Spannung eines Zellenmoduls Vzm_soll aus der Berechnung Vzm_soll = Vbat/N (Schritt ii. in Anspruch 1) führt somit zu einem Mittelwert der Spannung der Batterie, bezogen auf ein jeweiliges Zellenmodul. Dieser Spannungsverlauf kann als eine Referenzkennlinie grafisch dargestellt werden.

Die Ermittlung eines Soll-Differenzwertes ΔVzm_soll für die Spannungszunahme des Zellenmoduls bei Ladung der Batterie im Ladungszustandsbereich Q_BAT_START bis Q_BAT_STOP aus den ermittelten Werten der Soll-Spannung Vzm_soll (Schritt iii. in Anspruch 1) erfolgt für irgendein, also für ein ideelles Zellenmodul der Batterie.

Dabei kann das Verfahren derart ausgeführt werden, dass bei einer Durchführung des Verfahrens an nicht parallel geschalteten Zellenmodulen und Unterschreitung eines Grenzwertes von 70 % des SoH eine Information hinsichtlich der Fehlerhaftigkeit des betreffenden Zellenmoduls, dessen Ist-Differenzwert ΔVzm_ist ermittelt wurde, ausgegeben wird. Gegebenenfalls kann diese Information in Form eines Warnsignals ausgegeben werden. Hieraus ist ersichtlich, dass die verbleibende Kapazität des betreffenden Zellenmoduls nur noch 70 % des Endwertes ist.

Bei Durchführung des Verfahrens an P parallel geschalteten Zellenmodulen und Unterschreitung eines Grenzwertes von 70 % des SoH kann ebenfalls eine Information hinsichtlich der Fehlerhaftigkeit des betreffenden Zellenmoduls, dessen Ist-Differenzwert ΔVzm_ist ermittelt wurde, ausgegeben werden, auch hier ggf. auch in Form eines Warnsignals.

In einer weiteren Ausgestaltung des Verfahrens ist vorgesehen, dass eine Information hinsichtlich der Fehlerhaftigkeit des betreffenden Zellenmoduls ausgegeben wird, wenn die gemessene Kapazität um 1/P*100% zu gering ist, was z.B. bei fehlender Kontaktierung einer Zelle in einer Parallelanordnung der Fall ist. So kann z.B. bei einer Parallelschaltung von 6 Zellen in einem Zellenmodul und mangelnder Kontaktierung einer Zelle bzw. Fehlen einer Zelle und Ermittlung, dass die Kapazität dieser Zelle < 5/6 der Nennkapazität des betreffenden, aus der Parallelschaltung zusammengesetzten Zellenmoduls ist, ebenfalls eine Fehlermeldung generiert werden.

Derart ist es möglich, bei P parallel geschalteten Zellen zu erkennen, wenn eine Zelle fehlt bzw. nicht ausreichend kontaktiert ist. In diesem Fall ist die verbleibende Kapazität der anderen Zellen des Zellenmoduls (Restzellen) (P-1)/P, nämlich die Kapazitätsdifferenz 1/P. Beispielsweise hat bei einer Parallelschaltung von 6 Zellen (P = 6) zu einem Zellenmodul und einer Kapazität je Zelle von 100Ah die Parallelschaltung bzw. das Zellenmodul eine Kapazität von 600Ah. Bei Fehlen einer Zelle bzw. mangelhafter Kontaktierung einer Zelle weist das Zellenmodul nur noch eine Kapazität von 500Ah auf. Das heißt, dass 1/P*600Ah=1/6*600Ah =100Ah an Kapazität im Vergleich zu einem vollständigen Zellenmodul fehlen. Die verbleibende Kapazität des Zellenmoduls ist dann (P-1)/P=500Ah. Bezogen auf die Ausgangskapazität wäre dies dann 500Ah/600Ah =5/6 oder 91,3%. Das bedeutet, dass in einem solchen Fall einer fehlenden Zelle bzw. einer mangelhaft kontaktierten Zelle eine fehlende Kapazität von 8,3% oder ein SoH von 91,7% erkennbar ist.

Der definierte Ladebereich bei Ladung der Batterie kann der gesamte Ladebereich der Batterie sein.

Weiterhin kann das Zellenmodul durch eine einzelne Batteriezelle oder durch mehrere miteinander parallel geschaltete Batteriezellen ausgebildet sein.

Die Ermittlung des Soll-Differenzwertes ΔVzm_soll (Schritt iii.) kann durch die Berechnung

$$\Delta Vzm\_soll = |Vzm\_start - Vzm\_stop|$$

erfolgen.

Das heißt, dass der Wert des Betrages der Spannung des Zellenmoduls bei Q_BAT_START abzüglich des Wertes der Spannung des Zellenmoduls bei Q_BAT_STOP ermittelt wird. Insbesondere kann der Ladungszustandsbereichs der Batterie Q_BAT_START bis Q_BAT_STOP 2% bis 20%, insbesondere 5% bis 15% der Kapazität der Batterie entsprechen.

Dabei kann der Ladungszustandsbereich der Batterie Q_BAT_START bis Q_BAT_STOP bei 70% bis 80% des vollständigen Ladungszustandes der Batterie verwendet werden.

Dieser Messbereich sollte in einem relativ flachen Bereich der Ladekennlinie der Batterie verlaufen, die sich aus der Ermittlung der Soll-Spannung eines Zellenmoduls Vzm_soll aus der Berechnung Vzm_soll = Vbat/N ergibt.

Insbesondere kann der Messbereich zwischen 30% und 85% SoC definiert sein.

Die Messung der Spannungszunahme der Batterie Vbat kann insbesondere über den definierten Ladebereich bei einer elektrischen Ladung von 0,5 C erfolgen. Dabei kann die Batterie eine Temperatur von 20 °C aufweisen.

Zwecks Kompensierung des Ist-Differenzwertes ΔVzm_ist wird ein Kompensierungsfaktor k aufgestellt, wobei die Größe des Kompensierungsfaktors k abhängt von der Abweichung der Temperatur der Batterie von einem definierten Temperaturbereich und/ oder von der Abweichung der elektrischen Ladung der Batterie von einem definierten Ladestrom bei der Messung des Ist-Differenzwertes ΔVzm_ist. Der ermittelte Kompensierungsfaktor k wird mit dem ermittelten Kapazitätszustand SoH zu einem kompensierten Kapazitätszustand SoHk mit der folgenden Berechnungsmethode verrechnet:

$$SoHk = \Delta Vzm\_ist * k / \Delta Vzm\_soll.$$

Der definierte Temperaturbereich kann ggf. 15-25 °C, insbesondere 18-22 °C; und der definierte Ladestrom 0,4 C bis 0,6 C; insbesondere 0,5 C sein.

Das heißt, dass der Ladestrom 0,4 bis 0,6; insbesondere 0,5 * der Batteriekapazität in Ah beträgt. Eine 100Ah Batterie würde somit mit 0,5 C oder 50 A geladen und benötigt bei 0,5 C Ladestrom 2 h bis sie voll geladen ist. Eine weitere Bezeichnung ist, dass der Ladestrom IL=0,4 C bis 0,6 C/1h ist, insbesondere 0,5 C/1h beträgt.

Der Kompensierungsfaktor k kann insbesondere aus zuvor ermittelten Werten des gemessenen Ist-Differenzwertes ΔVzm_ist in Abhängigkeit von der Abweichung der bei der jeweiligen Messung vorliegenden Batterietemperatur und/ oder des jeweils vorliegenden Ladestroms von der Batterietemperatur bzw. dem Ladestrom, der bzw. die bei der Messung des mit dem Soll-Differenzwert ΔVzm_soll zu verrechnenden Ist-Differenzwertes ΔVzm_ist vorliegt bzw. vorliegen, ermittelt werden.

Beispielsweise kann der Kompensierungsfaktor k aus einer Normierungstabelle abgeleitet werden, in der in Abhängigkeit von der jeweils herrschenden Batterietemperatur und/ oder dem jeweils anliegenden Ladestrom davon beeinflusste Ist-Differenzwerte ΔVzm_ist abgelegt sind.

Alternativ oder hinzukommend können auch die sich aus unterschiedlichen Batterietemperaturen bzw. anliegenden Ladeströmen ergebende Kennlinien des Spannungsverlaufes des jeweiligen Zellenmoduls gespeichert werden, so dass eine Kurvenschar vorliegt, aus denen dann der Kompensierungsfaktor k ableitbar ist.

Der Kompensationsfaktor wird z.B. ermittelt, indem man eine Spannungskurvenschar abhängig vom Ladestrom empirisch ermittelt und die prozentuale Abweichung vom Normwert der Kurve bei einer definierten Stromstärke I (z.B. bei 0,5 C bzw. 50 A) wie folgt tabellarisch ermittelt:
Messung der relativen Ladespannungsabweichung vom Ladespannungswert bei der definierten Stromstärke (z.B. 0,5C) für einige Werte der Ladung (SoC) und einige Stromwerte. Ermittlung einer auf die definierte Stromstärke normierten Normierungsfaktormatrix KI(I,SoC) für den Strom. Gleiches gilt für die empirische Ermittlung einer Normierungsfaktormatrix für die Temperatur KT(T,SoC).

Der Gesamtnormierungsfaktor k ist das Produkt aus beiden Normierungsfaktoren

$$k=KI(IL,SoC)*KT(T,SoC).$$

In der praktischen Anwendung kann ggf. der Normierungsfaktor KT vernachlässigt werden, ebenfalls die Abhängigkeit des Normierungsfaktors vom SoC, so dass in guter Näherung k=KI(IL) ansetzbar ist.

Die normierte Zellenmodulspannung ergibt sich dann zu Vzmnorm=k*Vzmist.

Der kompensierte Kapazitätszustand SoHk lässt sich wie folgt ermitteln: SoHk = ΔVzm_ist *k/ ΔVzm_soll.

Zur Lösung der Aufgabe wird außerdem eine Vorrichtung zur Ermittlung einer geminderten Kapazität eines Zellenmoduls innerhalb einer mehrere Zellenmodule nach Anspruch 7 zur Verfügung gestellt.

Das heißt, dass die erfindungsgemäße Vorrichtung zur Ermittlung einer geminderten Kapazität eines Zellenmoduls dazu eingerichtet ist, das erfindungsgemäße Verfahren zur Ermittlung einer geminderten Kapazität eines Zellenmoduls auszuführen. Nach Definition eines Ladungszustandsbereichs der Batterie Q_BAT_START bis Q_BAT_STOP die kann Vorrichtung das erfindungsgemäße Verfahren automatisiert umsetzen.

Gegebenenfalls sind die erste Spannungsmesseinrichtung und die zweite Spannungsmesseinrichtung in einer Spannungsmesseinheit ausgebildet, mit der die erste Spannungsmessung und die zweite Spannungsmessung ausführbar ist.

Weiterhin können auch die erste Berechnungseinrichtung, die zweite Berechnungseinrichtung und/ oder die dritte Berechnungseinrichtung in einer Berechnungseinheit ausgebildet sein, mit der die erste Berechnung, die zweite Berechnung und/ oder die dritte Berechnung ausführbar ist.

Weiterhin wird zur Lösung der Aufgabe ein Batteriesystem zur Verfügung gestellt, welches eine mehrere Zellenmodule aufweisende elektrochemische Batterie sowie wenigstens eine erfindungsgemäße Vorrichtung zur Ermittlung einer geminderten Kapazität eines Zellenmoduls gemäß Anspruch 7 innerhalb der Batterie aufweist.

Die erfindungsgemäße Vorrichtung ist dabei gegebenenfalls derart mit der Batterie bzw. deren Zellen oder Zellenmodulen gekoppelt, dass die Spannungsmessungen automatisiert vornehmbar sind.

Ergänzt wird die vorliegende Erfindung durch ein Computerprogramm mit Programmcode zur Durchführung aller erfindungsgemäßen Verfahrensschritte, wenn das Computerprogramm in einem Computer ausgeführt wird.

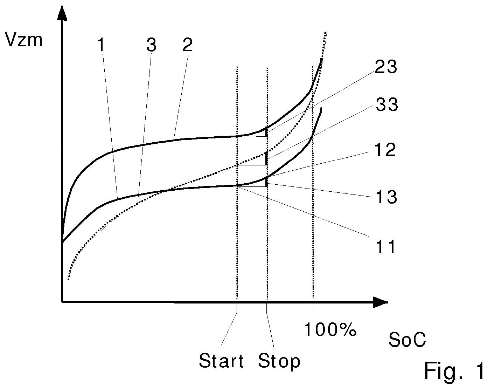

Die Erfindung wird im Folgenden anhand des in der einzigen Figur 1 dargestellten Diagramms erläutert.

Dieses Diagramm zeigt Spannungsverläufe unterschiedlicher Zellenmodule, bezogen auf den jeweiligen Ladungszustand "State of Charge" (SoC).

Mit der Funktion 1 ist eine Nennkennlinie dargestellt, die für ein Zellenmodul definiert ist. Diese Nennkennlinie wird durch die Messung des Spannungsverlaufes einer Gesamt-Batterie über den vorzugsweise gesamten Ladebereich und ggf. bei einer Temperatur von 20 °C und einem Referenzstrom von 0,5 C ermittelt. Durch die Division des ermittelten Spannungsverlaufs der gesamten Batterie durch die Anzahl N der seriell geschalteten Zellenmodule ist die dargestellte Nennkennlinie 1 definierbar.

Es ist ersichtlich, dass der Spannungsverlauf vom jeweiligen Ladezustand abhängt.

Insofern eine Zelle bzw. ein Zellenmodul einen erhöhten Innenwiderstand aufweist (unter der Voraussetzung des gleichen Ladestroms und der gleichen Temperatur wie bei der Definition der Nennkennlinie 1 ergibt sich eine Parallelverschiebung der Nennkennlinie 1, so dass eine verschobene Kennlinie 2 definiert wird. Der erhöhte Innenwiderstand kann z. B. durch Fertigungsfehler der Batteriezelle bzw. des Batteriezellmoduls aber auch durch schlechte Kontaktierung der Zelle bzw. des Moduls verursacht sein.

Bei einer Betrachtung des jeweiligen Funktionsverlaufes zwischen den Punkten Start und Stop, die vorzugsweise in einem relativ flachen Bereich der Funktionen zu definieren ist und nicht mehr als 10% der gesamten Kapazität der Batterie ausmachen sollte, wird zu der Nennkennlinie 1 sowie auch zu der verschobenen Kennlinie 2 zwischen den Punkten Start und Stop ein erster Spannungszustand Vzm_start 11 sowie ein zweiter Spannungszustand Vzm_stop 12 ermittelt. Es ist ersichtlich, dass, bedingt durch die Parallelverschiebung der Nennkennlinie zur verschobenen Kennlinie 2 der Betrag der Differenz des ersten Spannungszustandes Vzm_start 11 und des zweiten Spannungszustandes Vzm_stop 12 genauso groß ist.

Das heißt, dass die Differenz in der Nennkennlinie 1 ΔVzm_soll 13, die durch den Betrag aus der Differenz des ersten Spannungszustand Vzm_start 11 und des zweiten Spannungszustandes Vzm_stopp 12 gebildet ist, ist genauso groß ist wie die Differenz in der verschobenen Kennlinie 2 ΔVzm_soll 23, die aus den entsprechenden Spannungswerten dieser Kennlinie zwischen den Punkten Start und Stop gebildet ist.

Eine Zelle oder ein Zellmodul, welches einen hohen Alterungszustand (geminderten "State of Health") aufweist und demzufolge eine niedrige bzw. schlechte Kapazität hat, weist bei Ladung der Batterie eine Kennlinie einer geminderten Kapazität 3 auf. Es ist ersichtlich, dass diese Kennlinie 3 einen insgesamt steileren Verlauf aufweist als die Nennkennlinie 1 sowie auch die verschobene Kennlinie 2. Im definierten Ladungsbereich zwischen Start und Stop ergibt sich dadurch ein höherer Anstieg der Spannung, wie mit der Differenz ΔVzm_ist 33 in der Kennlinie einer geminderten Kapazität 3 dargestellt ist. Dieser größere Anstieg ist z. B. Alterung, Fertigungsfehler oder auch dem Fehlen einer Zelle einer Gruppenanordnung geschuldet und bewirkt einen schnelleren Spannungsanstieg im Vergleich zur Nennkennlinie 1 bzw. zur verschobenen Kennlinie 2.

Der Alterungszustand des betreffenden Zellenmoduls lässt sich nunmehr dadurch einschätzen oder bestimmen, indem als sogenannter Alterungszustand SoH der Quotient aus der Differenz ΔVzm_ist 33 in der Kennlinie einer geminderten Kapazität 3 und der Differenz ΔVzm_soll in der Nennkennlinie 1 oder auch in der verschobenen Kennlinie 2 gebildet wird. Je größer dabei der für SoH ermittelte Wert ist, umso größer ist die Abweichung der Spannungsdifferenz des untersuchten Zellenmoduls und demzufolge sein Alterungszustand.

**Bezugszeichenliste**

| | |
|---|---|
| Nennkennlinie | 1 |
| Verschobene Kennlinie | 2 |
| Kennlinie einer geminderten Kapazität | 3 |
| Erster Spannungszustand Vzm_start | 11 |
| Zweiter Spannungszustand Vzm_stop | 12 |
| Differenz in Nennkennlinie ΔVzm_soll | 13 |
| Differenz in verschobener Kennlinie ΔVzm_soll | 23 |
| Differenz in Kennlinie einer geminderten Kapazität ΔVzm_ist | 33 |

**Patentansprüche**

1. Verfahren zur Ermittlung einer geminderten Kapazität eines Zellenmoduls innerhalb einer mehrere Zellenmodule umfassenden elektrochemischen Batterie, bei dem die folgenden Schritte durchgeführt werden:

   i. Definition eines Ladungszustandsbereichs der Batterie Q_BAT_START bis Q_BAT_STOP;
   i.1 Messung der Spannungszunahme der Batterie Vbat über einen definierten Ladebereich bei Ladung der Batterie;
   ii. Ermittlung der Soll-Spannung eines Zellenmoduls Vzm_soll aus der Berechnung Vzm_soll = Vbat/N über den definierten Ladebereich bei Ladung der Batterie, wobei N die Anzahl der seriell geschalteten Zellenmodule der Batterie ist;
   iii. Ermittlung eines Soll-Differenzwertes ΔVzm_soll für die Spannungszunahme des Zellenmoduls bei Ladung der Batterie im Ladungszustandsbereich Q_BAT_START bis Q_BAT_STOP aus den ermittelten Werten der Soll-Spannung Vzm_soll eines Zellenmoduls;
   iv. Berechnung des Ist-Differenzwertes ΔVzm_ist für die Spannungszunahme eines bestimmten Zellenmoduls bei Ladung der Batterie im Ladungszustandsbereich Q_BAT_START bis Q_BAT_STOP;
   v. Ermittlung eines Kapazitätszustandes SoH des bestimmten Zellenmoduls aus der Berechnung

$$SoH = \Delta Vzm\_ist / \Delta Vzm\_soll;$$

   vi. Generierung einer Aussage aus dem ermittelten Kapazitätszustand SoH über die Minderung der Kapazität des bestimmten Zellenmoduls,

   **dadurch gekennzeichnet, dass** zwecks Kompensierung des Ist-Differenzwertes ΔVzm_ist ein Kompensierungsfaktor k aufgestellt wird, wobei die Größe des Kompensierungsfaktors k abhängt von der Abweichung der Temperatur der Batterie von einem definierten Temperaturbereich und/ oder von der Abweichung der elektrischen Ladung der Batterie von einem definierten Ladungsbereich bei der Berechnung des Ist-Differenzwertes ΔVzm_ist, und dass der ermittelte Kompensierungsfaktor k mit dem ermittelten Kapazitätszustand SoH zu einem kompensierten Kapazitätszustand SoHk verrechnet wird:

$$SoHk = \Delta Vzm\_ist * k / \Delta Vzm\_soll.$$

2. Verfahren zur Ermittlung einer geminderten Kapazität eines Zellenmoduls innerhalb einer mehrere Zellenmodule umfassenden elektrochemischen Batterie nach Anspruch 1, **dadurch gekennzeichnet, dass** der definierte Ladebereich bei Ladung der Batterie der gesamte Ladebereich ist.

3. Verfahren zur Ermittlung einer geminderten Kapazität eines Zellenmoduls innerhalb einer mehrere Zellenmodule umfassenden elektrochemischen Batterie nach einem der vorhergehenden Ansprüche, **dadurch gekennzeichnet, dass** das Zellenmodul durch eine einzelne Batteriezelle oder durch mehrere miteinander parallel geschaltete Batteriezellen ausgebildet ist.

4. Verfahren zur Ermittlung einer geminderten Kapazität eines Zellenmoduls innerhalb einer mehrere Zellenmodule umfassenden elektrochemischen Batterie nach einem der vorhergehenden Ansprüche **dadurch gekennzeichnet, dass** die Ermittlung des Soll-Differenzwertes ΔVzm_soll durch die Berechnung ΔVzm_soll = |Vzm_start - Vzm_stop| erfolgt.

5. Verfahren zur Ermittlung einer geminderten Kapazität eines Zellenmoduls innerhalb einer mehrere Zellenmodule umfassenden elektrochemischen Batterie nach einem der vorhergehenden Ansprüche, **dadurch gekennzeichnet, dass** der Ladungszustandsbereichs der Batterie Q_BAT_START bis Q_BAT_STOP 2% bis 20%, insbesondere 5% bis 15% der Kapazität der Batterie entspricht.

6. Verfahren zur Ermittlung einer geminderten Kapazität eines Zellenmoduls innerhalb einer mehrere Zellenmodule umfassenden elektrochemischen Batterie nach einem der vorhergehenden Ansprüche , **dadurch gekennzeichnet, dass** der Kompensierungsfaktor k ermittelt wird aus zuvor ermittelten Werten des berechneten Ist-Differenzwertes ΔVzm_ist in Abhängigkeit von der Abweichung der bei der jeweiligen Messung vorliegenden Batterietemperatur und/ oder des jeweils vorliegenden Ladestroms von der Batterietemperatur bzw. dem Ladestrom, der bzw. die bei der Messung des mit dem Soll-Differenzwert ΔVzm_soll zu verrechnenden Ist-Differenzwertes ΔVzm_ist vorliegt bzw. vorliegen.

7. Vorrichtung zur Ermittlung einer geminderten Kapazität eines Zellenmoduls innerhalb einer mehrere Zellenmodule umfassenden elektrochemischen Batterie, umfassend:

   - eine erste Spannungsmesseinrichtung zur Messung der Spannungszunahme der Batterie Vbat über einen definierten Ladebereich bei Ladung der Batterie;
   - eine erste Berechnungseinrichtung zur Ermittlung der Soll-Spannung eines Zellenmoduls Vzm_soll aus der Berechnung Vzm_soll = Vbat/N über den definierten Ladebereich bei Ladung der Batterie, wobei N die Anzahl der seriell geschalteten Zellenmodule der Batterie ist;
   - eine zweite Berechnungseinrichtung zur Ermittlung eines Soll-Differenzwertes ΔVzm_soll für die Spannungszunahme eines Zellenmoduls bei Ladung der Batterie in einem Ladungszustandsbereich Q_BAT_START bis Q_BAT_STOP aus den ermittelten Werten der Soll-Spannung Vzm_soll eines Zellenmoduls; wobei die Ermittlung des Soll-Differenzwertes ΔVzm_soll durch die Berechnung ΔVzm_soll = |Vzm_start - Vzm_stop| erfolgt;
   - eine zweite Spannungsmesseinrichtung zur Berechnung des Ist-Differenzwertes ΔVzm_ist für die Spannungszunahme eines bestimmten Zellenmoduls bei Ladung der Batterie im Ladungszustandsbereich Q_BAT_START bis Q_BAT_STOP;
   - eine dritte Berechnungseinrichtung zur Ermittlung eines Kapazitätszustandes des bestimmten Zellenmoduls SoH aus der Berechnung

$$SoH = \Delta Vzm\_ist / \Delta Vzm\_soll;$$

   sowie
   - eine Ausgabeeinrichtung zur Ausgabe einer Aussage aus dem ermittelten Kapazitätszustand SoH über die Minderung der Kapazität des bestimmten Zellenmoduls, **dadurch gekennzeichnet, dass** die Vorrichtung weiterhin eine Kompensierungseinrichtung umfasst, die dazu eingerichtet ist, zwecks Kompensierung des Ist-Differenzwertes ΔVzm_ist ein Kompensierungsfaktor k aufzustellen, wobei die Größe des Kompensierungsfaktors k abhängt von der Abweichung der Temperatur der Batterie von einem definierten Temperaturbereich und/ oder von der Abweichung der elektrischen Ladung der Batterie von einem definierten Ladungsbereich bei der Berechnung des Ist-Differenzwertes ΔVzm_ist,und mit der der ermittelte Kompensierungsfaktor k mit dem ermittelten Kapazitätszustand SoH zu einem kompensierten Kapazitätszustand SoHk verrechenbar ist: SoHk = ΔVzm_ist *k / ΔVzm_soll.

8. Batteriesystem, umfassend eine mehrere Zellenmodule aufweisende elektrochemische Batterie sowie eine Vorrichtung zur Ermittlung einer geminderten Kapazität eines Zellenmoduls gemäß Anspruch 7 innerhalb der Batterie.

**Claims**

1. A method for determining a reduced capacity of a cell module within an electrochemical battery comprising multiple cell modules, in which the following steps are performed:

    i. Definition of a state of charge range of the battery Q_BAT_START to Q_BAT_STOP;
    i.1 Measurement of the voltage increase of the battery Vbat over a defined charging range when charging the battery;
    ii. Determination of the nominal voltage of a cell module Vzm_soll from the calculation Vzm_soll = Vbat/N over the defined charging range when charging the battery, wherein N is the number of serially connected cell modules of the battery;
    iii. Determination of a nominal differential value ΔVzm_soll for the voltage increase of the cell module when charging the battery in the state of charge range Q_BAT_START to Q_BAT_STOP from the determined values of the nominal voltage Vzm_soll of a cell module;
    iv. Calculation of the actual differential value ΔVzm_ist for the voltage increase of a specific cell module when charging the battery in the state of charge range Q_BAT_START to Q_BAT_STOP;
    v. Determination of a capacity level SoH of the specific cell module from the calculation

$$SoH = \Delta Vzm\_ist\ /\ \Delta Vzm\_soll;$$

    vi. Generation of a statement from the determined capacity level SoH about the reduction in the capacity of the specific cell module,

    **characterized in that**, in order to compensate for the actual differential value ΔVzm_ist, a compensation factor k is established, wherein the size of the compensation factor k depends on the deviation of the temperature of the battery from a defined temperature range and/or on the deviation of the electrical charge of the battery from a defined charging range when calculating the actual differential value ΔVzm_ist, and the determined compensation factor k is offset by the determined capacity level SoH to produce a compensated capacity level SoHk:

$$SoHk = \Delta Vzm\_ist\ *k\ /\ \Delta Vzm\_soll.$$

2. The method for determining a reduced capacity of a cell module within an electrochemical battery comprising multiple cell modules according to Claim 1, **characterized in that** the defined charging range when charging the battery is the entire charging range.

3. The method for determining a reduced capacity of a cell module within an electrochemical battery comprising multiple cell modules according to any one of the preceding claims, **characterized in that** the cell module is configured by an individual battery cell or by multiple battery cells connected in parallel to one another.

4. The method for determining a reduced capacity of a cell module within an electrochemical battery comprising multiple cell modules according to any one of the preceding claims, **characterized in that** the nominal differential value ΔVzm_soll is determined by calculating ΔVzm_soll = | Vzm_start - Vzm_stop |.

5. The method for determining a reduced capacity of a cell module within an electrochemical battery comprising multiple cell modules according to any one of the preceding claims, **characterized in that** the state of charge range of the battery Q_BAT_START to Q_BAT_STOP corresponds to 2% to 20%, in particular 5% to 15% of the capacity of the battery.

6. The method for determining a reduced capacity of a cell module within an electrochemical battery comprising multiple cell modules according to any one of the preceding claims, **characterized in that** the compensation factor k is determined from previously determined values of the calculated actual differential value ΔVzm_ist as a function of the deviation of the battery temperature existing during the respective measurement and/or of the charging current existing in each case from the battery temperature or the charging current, which exists during the measurement of the actual differential value ΔVzm_ist to be offset by the nominal differential value ΔVzm_soll.

7. A device for determining a reduced capacity of a cell module within an electrochemical battery comprising multiple cell modules, comprising:

- a first voltage measuring apparatus for measuring the voltage increase of the battery Vbat over a defined charging range when charging the battery;
- a first calculating apparatus for determining the nominal voltage of a cell module Vzm_soll from the calculation Vzm_soll = Vbat/N over the defined charging range when charging the battery, wherein N is the number of serially connected cell modules of the battery;
- a second calculating apparatus for determining a nominal differential value ΔVzm_soll for the voltage increase of a cell module when charging the battery in a state of charge range Q_BAT_START to Q_BAT_STOP from the determined values of the nominal voltage Vzm_soll of a cell module; wherein the nominal differential value ΔVzm_soll is determined by the calculation ΔVzm_soll = | Vzm_start - Vzm_stop | ;
- a second voltage measuring apparatus for calculating the actual differential value ΔVzm_ist for the voltage increase of a specific cell module when charging the battery in the state of charge range Q_BAT_START to Q_BAT_STOP;
- a third calculating apparatus for determining a capacity level of the specific cell module SoH from the calculation

$$SoH = \Delta Vzm\_ist \, / \, \Delta Vzm\_soll;$$

as well as
- an output apparatus for outputting a statement from the determined capacity level SoH regarding the reduction in the capacity of the specific cell module, **characterized in that** the device furthermore comprises a compensation apparatus which is designed, in order to compensate for the actual differential value ΔVzm_ist, to establish a compensation factor k, wherein the size of the compensation factor k depends on the deviation of the temperature of the battery from a defined temperature range and/or on the deviation of the electrical charge of the battery from a defined charge range when calculating the actual differential value ΔVzm_ist, and with which the determined compensation factor k is offsetable by the determined capacity level SoH to produce a compensated capacity level SoHk: SoHk = ΔVzm_ist *k / ΔVzm_soll.

8.  A battery system, comprising an electrochemical battery having multiple cell modules as well as a device for determining a reduced capacity of a cell module according to Claim 7 within the battery.

**Revendications**

1.  Procédé pour la détermination d'une capacité réduite d'un module d'éléments dans une batterie électrochimique comprenant plusieurs modules d'éléments, lors duquel les étapes suivantes sont effectuées :

    i. Définition d'une plage d'état de charge de la batterie de Q_BAT_START à Q_BAT_STOP ;
    i.1 Mesure de l'augmentation de tension de la batterie Vbat sur une plage de charge définie lors de la charge de la batterie ;
    ii. Détermination de la tension de consigne d'un module d'éléments Vzm_soll par le calcul Vzm_soll = Vbat/N sur la plage de charge définie lors de la charge de la batterie, N étant le nombre des modules d'éléments de la batterie connectés en série ;
    iii. Détermination d'une valeur de différence de consigne ΔVzm_soll pour l'augmentation de tension du module d'éléments lors de la charge de la batterie dans la plage d'état de charge de Q_BAT_START à Q_BAT_STOP à partir des valeurs déterminées de la tension de consigne Vzm_soll d'un module d'éléments ;
    iv. Calcul de la valeur de différence réelle ΔVzm_ist pour l'augmentation de tension d'un module d'éléments spécifique lors de la charge de la batterie dans la plage d'état de charge de Q_BAT_START à Q_BAT_STOP ;
    v. Détermination d'un état de capacité SoH du module d'éléments spécifique à l'aide de la formule SoH = ΔVzm_ist / ΔVzm_soll ;
    vi. Génération d'une déclaration sur la diminution de la capacité du module d'éléments spécifique en se basant sur l'état de capacité déterminé SoH ;

    **caractérisé en ce qu'**un facteur de compensation k est établi en vue de la compensation de la valeur de différence réelle ΔVzm_ist, la grandeur du facteur de compensation k étant fonction de l'écart de la température de la batterie d'une plage de température définie et/ou de l'écart de la charge électrique de la batterie d'une plage de charge définie lors du calcul de la valeur de différence réelle ΔVzm_ist, et **en ce qu'**un état de capacité compensé SoHk est calculé à l'aide du facteur de compensation k déterminé et de l'état de capacité déterminé SoH :

$$SoHk = \Delta Vzm\_ist *k/ \Delta Vzm\_soll.$$

2. Procédé pour la détermination d'une capacité réduite d'un module d'éléments dans une batterie électrochimique comprenant plusieurs modules d'éléments selon la revendication 1, **caractérisé en ce que** la plage de charge définie lors de la charge de la batterie est la totalité de la plage de charge.

3. Procédé pour la détermination d'une capacité réduite d'un module d'éléments dans une batterie électrochimique comprenant plusieurs modules d'éléments selon l'une des revendications précédentes, **caractérisé en ce que** le module d'éléments est formé par un élément de batterie individuel ou par plusieurs éléments de batterie connectés en parallèle entre eux.

4. Procédé pour la détermination d'une capacité réduite d'un module d'éléments dans une batterie électrochimique comprenant plusieurs modules d'éléments selon l'une des revendications précédentes, **caractérisé en ce que** la détermination de la valeur de différence de consigne $\Delta Vzm\_soll$ est effectuée par le calcul $\Delta Vzm\_soll = |\ Vzm\_start - Vzm\_stop\ |$.

5. Procédé pour la détermination d'une capacité réduite d'un module d'éléments dans une batterie électrochimique comprenant plusieurs modules d'éléments selon l'une des revendications précédentes, **caractérisé en ce que** la plage de charge de Q_BAT_START à Q_BAT_STOP correspond à de 2% à 20%, en particulier à de 5% à 15% de la capacité de la batterie.

6. Procédé pour la détermination d'une capacité réduite d'un module d'éléments dans une batterie électrochimique comprenant plusieurs modules d'éléments selon l'une des revendications précédentes, **caractérisé en ce que** le facteur de compensation k est déterminé à partir de valeurs de la valeur de différence réelle $\Delta Vzm\_ist$ calculée déterminées précédemment en fonction de l'écart de la température de batterie, présente lors de la mesure respective, avec la température de batterie et/ou de l'écart du courant de charge, présent respectivement, avec le courant de charge, laquelle température de batterie ou lequel courant de charge sont présents lors de la mesure de la valeur de différence réelle $\Delta Vzm\_ist$ devant être compensée en fonction de la valeur de différence de consigne $\Delta Vzm\_soll$.

7. Dispositif pour la détermination d'une capacité réduite d'un module d'éléments dans une batterie électrochimique comprenant plusieurs modules d'éléments, comprenant :

   - un premier dispositif de mesure de tension pour la mesure de l'augmentation de tension de la batterie Vbat sur une plage de charge définie lors de la charge de la batterie ;
   - un premier dispositif de calcul pour la détermination de la tension de consigne d'un module d'éléments Vzm_soll à partir du calcul Vzm_soll = Vbat/N sur la plage de charge définie lors de la charge de la batterie, N étant le nombre des modules d'éléments de la batterie connectés en série ;
   - un deuxième dispositif de calcul pour la détermination d'une valeur de différence de consigne $\Delta Vzm\_soll$ pour l'augmentation de tension d'un module d'éléments lors de la charge de la batterie dans une plage d'état de charge de Q_BAT_START à Q_BAT_STOP à partir des valeurs déterminées de la tension de consigne Vzm_soll d'un module d'éléments ; la détermination de la valeur de différence de consigne $\Delta Vzm\_soll$ étant effectuée par le calcul $\Delta Vzm\_soll = |\ Vzm\_start - Vzm\_stop\ |$ ;
   - un deuxième dispositif de mesure de tension pour le calcul de la valeur de différence réelle $\Delta vzm\_ist$ pour l'augmentation de tension d'un module d'éléments spécifique lors de la charge de la batterie dans la plage d'état de charge de Q_BAT_START à Q_BAT_STOP ;
   - un troisième dispositif de calcul pour la détermination d'un état de capacité du module d'éléments spécifique SoH à partir de la formule

$$SoH = \Delta Vzm\_ist / \Delta Vzm\_soll ;$$

   ainsi que
   - un dispositif de sortie pour la sortie d'une déclaration à partir de l'état de capacité SoH déterminé relative à la diminution de la capacité du module d'éléments spécifique,

**caractérisé en ce que** le dispositif comprend en outre un dispositif de compensation, lequel est agencé afin d'établir un facteur de compensation k pour la compensation de la valeur de différence réelle $\Delta$Vzm, la grandeur du facteur de compensation k étant fonction de l'écart de la température de la batterie avec une plage de température définie et/ou de l'écart de la charge électrique de la batterie avec une plage de charge définie lors du calcul de la valeur de différence réelle $\Delta$Vzm_ist, et avec laquelle l'état de capacité compensé SoHk est calculable à l'aide du facteur de compensation k déterminé et de l'état de capacité déterminé SoH : SoHk = $\Delta$Vzm_ist *k / $\Delta$Vzm_soll.

8. Système de batterie, comprenant une batterie électrochimique présentant plusieurs modules d'éléments ainsi qu'un dispositif pour la détermination d'une capacité réduite d'un module d'éléments selon la revendication 7 dans la batterie.

Fig. 1

EP 3 196 664 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP H0968561 A